# EUROPEAN PATENT APPLICATION

(11) **EP 4 730 949 A1**
(43) Date of publication of application: **22.04.2026**
(21) Application number: 24214579.5
(22) Date of filing: 21.11.2024
(51) Int. Cl.: H10D 30/01, C23C 18/12, H10D 30/67, C04B 35/457, G03F 7/004, H01L 21/02

(54) **THIN-FILM TRANSISTOR WITH INORGANIC SEMICONDUCTOR CHANNEL AND METHOD OF MANUFACTURING THE SAME**

(30) Priority: 18.10.2024 KR 20240142890
(71) Applicant: Industry Foundation of Chonnam National University, Gwangju 61186 (KR)
(72) Inventor: JEONG, Hyun Dam, 61182 Gwangju (KR); YUN, Hyeok, 59454 Boseong-eup (KR); KEE, Won Chul, 61416 Gwangju (KR); BAEK, Seung Yong, 57352 Geumseong-myeon (KR); KIM, Ha Yun, Gwangju (KR)
(74) Representative: Marks & Clerk LLP

(57) **Abstract**

A thin-film transistor using an inorganic semiconductor layer as a channel layer and a method of manufacturing the same are disclosed. The channel layer is patterned, and an inorganic photosensitive layer is coated for the patterning. The inorganic photosensitive layer is formed as a patterned inorganic photosensitive layer through irradiation with extreme ultraviolet light or electron beams. When heat treatment is performed on an inorganic photosensitive layer pattern, the inorganic photosensitive layer pattern is modified into the patterned inorganic semiconductor layer. Accordingly, no separate photoresist is required to form the channel layer, and an etching process using a formed photoresist pattern is not necessary, so that process efficiency is improved.

## Description

### CLAIM FOR PRIORITY

This application claims priority to Korean Patent Application No. 2024-0142890 filed on OCT 18, 2024 in the Korean Intellectual Property Office (KIPO), the entire contents of which are hereby incorporated by reference.

### BACKGROUND

### 1. Technical Field

Example embodiments of the present invention relate to an electronic device with an inorganic semiconductor channel, and more particularly, to a thin-film transistor that uses an inorganic semiconductor as a channel, the inorganic semiconductor being patterned by extreme ultraviolet light or electron beams without the use of a photoresist, and a method of manufacturing the same.

### 2. Related Art

Semiconductor technology using silicon wafers has been steadily advancing. The key to advancing semiconductor technology is to increase the number of transistors included within a chip, and for this, a fine process is required. When the size of a transistor element is reduced, the distance electrons need to travel decreases, and the speed of response to electrical changes increases. In addition, the reduced size enables low-voltage operation, thereby increasing power efficiency.

A photolithography process is a crucial process for the miniaturization and reduction in size of devices. Photolithography is a type of printing technique that uses light, and when light is irradiated onto the top of a mask, patterns formed on the mask are transferred onto a photoresist by the light that passes through the patterns. The photoresist has the characteristic of undergoing chemical changes in areas exposed to ultraviolet light, extreme ultraviolet light, or electron beams. Typically, a patterning process uses differential development rates between exposed and unexposed areas. Patterning consists of an operation of recording an image by exposing a photoresist to an energy source through a mask and a developing operation of removing selected areas from the photoresist through development. A positive tone resist has the characteristic of being modified and selectively removed in areas exposed by ultraviolet light or the like, and a negative tone resist has the characteristic of being removed in areas not exposed by the ultraviolet light or the like.

Further, photoresists are classified into chemically amplified resists (CARs) and non-chemically amplified resists based on operating principles. The chemically amplified resist has a photoacid generator that generates acid when exposed to light, and an acid-catalyzed reaction occurs in the resist. The chemically amplified resist has the advantage of amplifying reactions even with a small amount of light, but has poor thermal stability and difficulties in achieving pattern formation accuracy and consistency due to stochastic effects.

Research is being conducted on inorganic photosensitive compositions to overcome the disadvantages of the chemically amplified resist. Inorganic photoresists have excellent etch resistance and high mechanical strength, and thus can be formed at very low thicknesses even in ultra-fine patterning, with the advantage of preventing pattern collapse.

However, the above-described inorganic photosensitive compositions are only used as photoresists and must be removed in subsequent processes. In other words, inorganic photoactive materials currently discussed in the industry are limited in their use as photoresists and must be removed during the manufacturing process of electronic devices.

When an inorganic photosensitive composition that can be simultaneously used as a photoresist and a semiconductor material is disclosed, subsequent processes such as an additional lamination process, an etching process, and an ashing process to remove the resist may no longer be required, and process convenience and device stability may be significantly improved.

### SUMMARY

A first technical object of the present invention is to provide a thin-film transistor that uses an inorganic semiconductor layer, which has been modified from an inorganic photosensitive layer having photosensitivity, to replace a photoresist.

A second technical object of the present invention is to provide a method of manufacturing a thin-film transistor to achieve the first technical object.

In some example embodiments, a thin-film transistor includes a gate electrode, a gate dielectric film formed on the gate electrode, an inorganic semiconductor layer formed on the gate dielectric film, and a source electrode and a drain electrode formed on the inorganic semiconductor layer, wherein the inorganic semiconductor layer is modified from acetic acid-stabilized tin dioxide through heat treatment.

In other example embodiments, a method of manufacturing a thin-film transistor includes forming a gate electrode, forming a gate dielectric film on the gate electrode; forming an inorganic semiconductor layer, which is modified from an inorganic photosensitive layer pattern including acetic acid-stabilized tin oxide, on the gate dielectric film, and forming a source electrode and a drain electrode on the inorganic semiconductor layer, wherein the inorganic semiconductor layer is formed by performing heat treatment on the inorganic photosensitive layer pattern.

### BRIEF DESCRIPTION OF DRAWINGS

Example embodiments of the present invention will become more apparent by describing in detail example embodiments of the present invention with reference to the accompanying drawings, in which:
FIGS. 1 to 3 are cross-sectional views for describing a method of manufacturing an inorganic semiconductor layer according to example embodiments of the present invention;
FIG. 4 is a schematic diagram of a molecular structure when an inorganic photosensitive layer illustrated in FIG. 2 is irradiated with electron beams or extreme ultraviolet light and a baking process is performed, according to the example embodiment of the present invention;
FIG. 5 is a schematic diagram of a molecular structure for describing the modification into an inorganic semiconductor layer through heat treatment illustrated in FIG. 3, according to the example embodiment of the present invention;
FIG. 6 is a cross-sectional view illustrating a thin-film transistor using an inorganic semiconductor according to the example embodiment of the present invention;
FIG. 7 is a graph illustrating a molecular structure and atomic composition of an inorganic photosensitive material according to Manufacturing Example 1 of the present invention;
FIG. 8 is an image illustrating an inorganic photosensitive layer pattern formed according to Manufacturing Example 2 of the present invention;
FIG. 9 is a graph obtained by measuring the sensitivity of an inorganic photosensitive layer according to Manufacturing Example 2 of the present invention;
FIG. 10 is a graph illustrating the transfer characteristics in a common source configuration of a thin-film transistor according to Manufacturing Example 3 of the present invention; and
FIG. 11 is a graph for confirming the operation of the thin-film transistor in a saturation region, according to Manufacturing Example 3 of the present invention.

### DESCRIPTION OF EXAMPLE EMBODIMENTS

While the present invention is susceptible to various modifications and alternative forms, specific example embodiments thereof are shown by way of example in the drawings and will herein be described in detail in the text. It should be understood, however, that there is no intent to limit the present invention to the particular forms disclosed, but on the contrary, the present invention is to cover all modifications, equivalents, and alternatives falling within the spirit and scope of the present invention. Similar reference numerals are used for similar elements in describing each drawing.

Unless otherwise defined, all terms used herein including technical or scientific terms have the same meanings as those generally understood by one of ordinary skill in the art. It should be further understood that terms, such as those defined in commonly used dictionaries, should be interpreted as having a meaning that is consistent with their meaning in the context of the relevant art and are not to be interpreted in an idealized or overly formal sense unless expressly so defined herein.

Hereinafter, exemplary embodiments of the present invention will be described in more detail with reference to the accompanying drawings.

Embodiment: Thin-film transistor using an inorganic semiconductor layer having self-patterning characteristics

In the present embodiment, a thin-film transistor using an inorganic semiconductor layer is provided. The inorganic semiconductor layer is derived from acetic acid-stabilized tin dioxide SnO₂(CH₃COOH)₂ and has a tin oxide network structure with repeated Sn-O-Sn bonds, and electron delocalization occurs throughout the entire area of the network.

The inorganic semiconductor layer is formed through the formation of an inorganic photosensitive layer, a patterning process of the inorganic photosensitive layer, and curing.

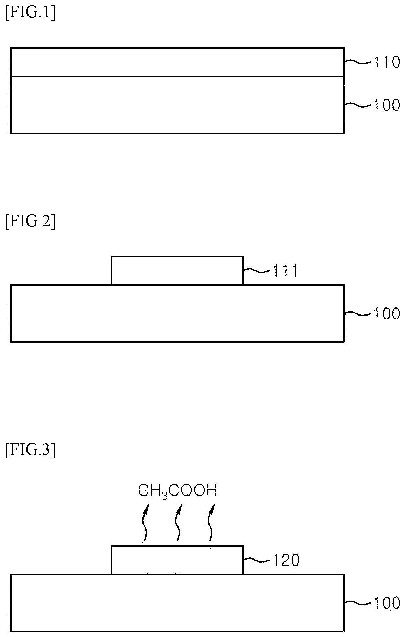

FIGS. 1 to 3 are cross-sectional views for describing a method of manufacturing an inorganic semiconductor layer according to example embodiments of the present invention.

Referring to FIG. 1, an inorganic photosensitive layer 110 is formed on a substrate 100. The substrate 100 may include a silicon material, and may be an underlying film on which an inorganic semiconductor layer is formed.

The inorganic photosensitive layer 110 is formed on the substrate 100 through a spin coating process. The inorganic photosensitive layer 110 includes acetic acid-stabilized tin dioxide.

The inorganic photosensitive layer 110 has a molecular solid state. A molecular solid refers to a form that appears solid externally but, microscopically, has no chemical bonds between molecules, which are instead aggregated together by van der Waals interactions. In the molecular solid, the movement of electrons mainly occurs due to the phenomenon of electron hopping between neighboring molecules. Accordingly, the electron mobility has a very low value of less than or equal to 0.1 cm²/(V·s).

Referring to FIG. 2, the inorganic photosensitive layer is irradiated with extreme ultraviolet light or electron beams. Subsequently, a baking process is performed at 200 °C to 250 °C for 1 minute, during which irradiated areas become insoluble, and the non-irradiated areas are dissolved and removed in a development process.

This occurs because most of the ligands bonded to the molecules forming the inorganic photosensitive layer dissociate due to electron beam irradiation, and, as shown in FIG. 2, inorganic polymers are formed in the electron beam irradiated areas as intermolecular bonding occurs during the baking process. However, since ligands are thermally dissociable, when the inorganic photosensitive layer is heated to a higher temperature, the ligands may gradually dissociate even in the areas not irradiated by electron beams, which causes intermolecular bonding. As a result, there is an issue in which the chemical contrast between the exposed and non-exposed areas decreases during the subsequent development process, which should be avoided.

The inventors of the present invention verified the baking process for the inorganic photosensitive layer with a focus on temperature, and found that when a baking temperature is below 200 °C, cross-linking between molecules is insufficient, causing the thin film to dissolve completely in a developing solution, which makes pattern formation impossible. In addition, when the baking temperature exceeds 250 °C, all areas, including the non-irradiated areas, will undergo thermal cross-linking, thereby preventing the developing solution from dissolving the thin film. The irradiated areas exhibit insolubility in tetramethylammonium hydroxide (TMAH). An inorganic photosensitive layer pattern 111 is formed through the development process.

After the electron beam irradiation and baking process, an inorganic polymer pattern is formed with most of the ligands removed. However, the unit size of the polymer is too small for use as an inorganic semiconductor layer. Since electron mobility is inversely proportional to the number of empty spaces that electrons must jump over when moving through the semiconductor layer, it is necessary to increase the unit size of the inorganic polymer through heat treatment after pattern formation.

Referring to FIG. 3, heat treatment is performed on the inorganic photosensitive layer pattern. The inorganic photosensitive layer is modified into an inorganic semiconductor layer 120 through heat treatment at 300 °C to 450 °C. The intermolecular cross-linking required to modify the inorganic photosensitive layer into an inorganic semiconductor layer needs to be greater than the amount of the intermolecular cross-linking required for photolithography. When the heat treatment temperature for the inorganic photosensitive layer pattern is below 300 °C, insufficient intermolecular cross-linking occurs, which prevents modification into an inorganic semiconductor layer. In addition, when the heat treatment temperature exceeds 450 °C, underlying layers undergo thermal deformation, and thus, semiconductors cannot be manufactured.

When the heat treatment is performed, neutral acetic acid molecules that form coordination bonds in the acetic acid-stabilized tin dioxide dissociate and are removed. During the removal process, a core structure of tin dioxide is formed, which is a thermodynamically very unstable state. Accordingly, chemical bonds are formed between tin dioxide core molecules, which corresponds to an addition polymerization reaction. Therefore, a network structure of tin oxide is formed, in which Sn-O-Sn bonds are repeated, and electron delocalization occurs within the network, and thus the inorganic semiconductor layer 120 is formed. In the inorganic semiconductor layer 120 in which electron delocalization occurs, electron transfer occurs due to an externally applied voltage, and the electron mobility can reach between 0.1 and 50 cm²/(V·s). During the heat treatment process, the neutral acetic acid molecules may remain within the inorganic semiconductor layer 120, and the higher the concentration of residual acetic acid molecules, the lower the electron mobility within the inorganic semiconductor layer.

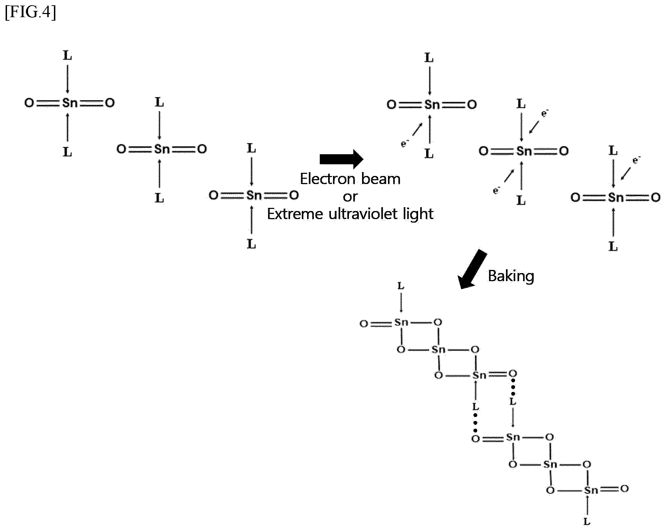

FIG. 4 is a schematic diagram of a molecular structure when the inorganic photosensitive layer illustrated in FIG. 2 is irradiated with electron beams or extreme ultraviolet light and the baking process is performed, according to the example embodiment of the present invention.

Referring to FIG. 4, when irradiated with electron beams or the like, the molecular structure of the spin-coated inorganic photosensitive layer is not fundamentally changed, but electrons are supplied to the areas irradiated by the electron beams or the like. In the spin-coated state, SnO₂(CH₃COOH)₂ is formed at the molecular level, and in the unit molecule, CH₃COOH acts as a ligand. In addition, the cationic ligand L (=CH₃COOH) forms a weak van der Waals bond with the oxygen atoms of SnO₂. When irradiated with electron beams or the like, the irradiated areas are supplied with electrons or light energy. Thus, the unit molecules enter an excited state due to the irradiation of electrons or light energy.

When heat energy generated through baking is supplied to the electrons supplied to the irradiated areas, the double bonds of SnO are converted into single bonds, and a polymer with Sn-O-Sn single bonds is formed. For example, the polymer has a molecular structure shown below, 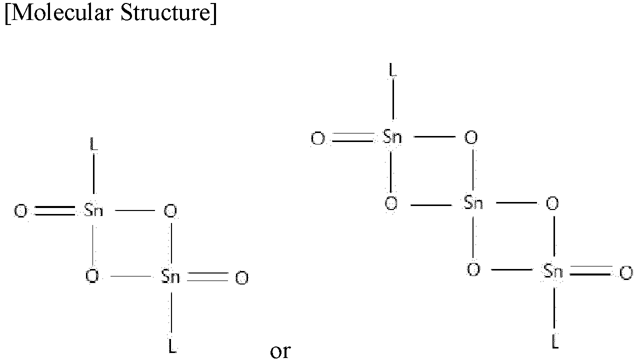 in the above molecular structure, L represents a ligand CH₃COOH.

The terminal of the polymer may be terminated with double-bonded oxygen and single-bonded CH₃COOH. In particular, the terminal ligand L (=CH₃COOH) forms a van der Waals bond with a double-bonded oxygen atom at the terminal of another polymer, thereby providing shape retention during the development process.

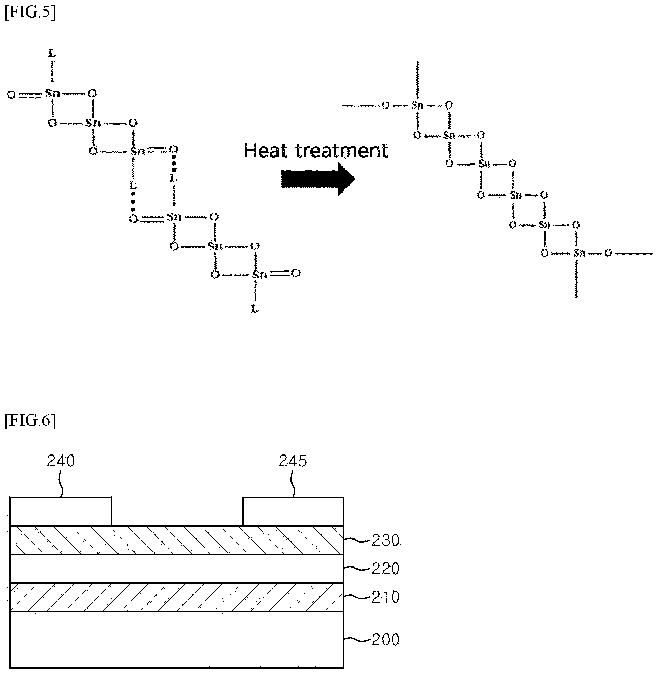

FIG. 5 is a schematic diagram of a molecular structure for describing the modification into an inorganic semiconductor layer during the heat treatment illustrated in FIG. 3, according to the example embodiment of the present invention.

Referring to FIG. 5, the terminal ligand L of the primary polymer is removed by the energy supplied during the heat treatment, and the double-bonded oxygen forms a single bond with the tin atom at the terminal of an adjacent primary polymer, thereby forming a Sn-O-Sn network structure. The above-described process should be understood as the removal of the ligand CH₃COOH and a secondary polymerization process.

FIG. 6 is a cross-sectional view illustrating a thin-film transistor using the inorganic semiconductor according to the example embodiment of the present invention.

Referring to FIG. 6, a gate electrode 210 is formed on a substrate 200. The gate electrode 210 is not particularly limited as long as it has a conductive material. Accordingly, a material with highly doped silicon or metal can be used as the gate electrode 210.

A gate dielectric film 220 is formed on the gate electrode 210. A material with polarization properties commonly used in conventional semiconductor processes is suitable for the gate dielectric film 220.

An inorganic semiconductor layer 230 acting as a channel layer is formed on the gate dielectric film 220. The inorganic semiconductor layer 230 is a patterned inorganic semiconductor, and a separate photoresist is not used to form a pattern. The inorganic semiconductor layer 230 is derived from acetic acid-stabilized tin dioxide SnO₂(CH₃COOH)₂, as described with reference to FIGS. 1 to 5.

First, an inorganic photosensitive layer is formed on the gate dielectric film 220. The inorganic photosensitive layer includes acetic acid-stabilized tin dioxide. The above material is dissolved in ethyl lactate to form a coating solution. The inorganic photosensitive layer is formed on the gate dielectric film 220 through spin coating using the coating solution.

Subsequently, a patterning process is performed on the inorganic photosensitive layer by irradiating the inorganic photosensitive layer with an electron beam or extreme ultraviolet light. Through this, an inorganic photosensitive layer pattern is formed. The inorganic photosensitive layer pattern includes tin dioxide stabilized with acetic acid.

Subsequently, vacuum heat treatment is performed at a temperature of 300 °C to 450 °C. The vacuum heat treatment is a process of discharging gases, which are generated during heat treatment, from the inorganic photosensitive layer pattern using a vacuum pump. Through the heat treatment, the inorganic photosensitive layer pattern is modified into the inorganic semiconductor layer 230. The inorganic semiconductor layer 230 acts as a channel in the thin-film transistor.

A source electrode 240 and a drain electrode 245 are formed on the inorganic semiconductor layer 230. The source electrode 240 and the drain electrode 245 are required to have a conventional metal material, which is not particularly limited.

Hereinafter, the preparation of the coating solution for forming an inorganic semiconductor layer, which is the core concept of the present invention, and the formation of the inorganic semiconductor pattern will be described through manufacturing examples.

### Manufacturing Example 1: Preparation of inorganic photosensitive material

An inorganic photosensitive material of the present manufacturing example can be mixed with a solvent to form an inorganic photosensitive solution, and when the inorganic photosensitive solution is spin-coated, an inorganic photosensitive layer is formed.

0.304 g of tin oxide powder, purchased from QURES Co., Ltd., was placed in a roundbottom flask, 16 ml of methanol was added, and then 24 ml of acetic acid was added. After the addition of acetic acid, the mixture was stirred at room temperature for 30 minutes to ensure even dispersion, and then heated to 70 °C while stirring for 15 hours to induce a reaction.

Finally, the solvent was removed using a vacuum pump, and a yellow solid was obtained. The solid material was acetic acid-stabilized tin dioxide having a composition of SnO₂(CH₃COOH)₂.

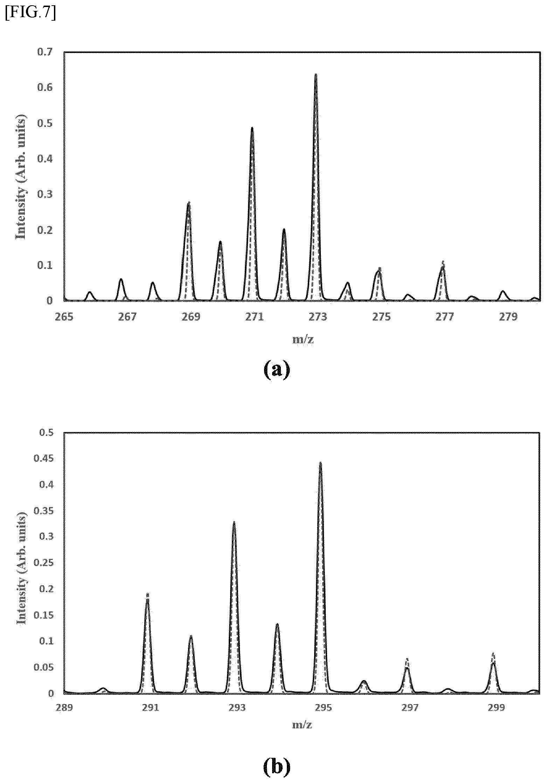

FIG. 7 is a graph illustrating a molecular structure and atomic composition of the inorganic photosensitive material according to Manufacturing Example 1 of the present invention.

Referring to FIG. 7, the atomic composition and molecular structure of the inorganic photosensitive material synthesized in Manufacturing Example 1 were confirmed using matrix-assisted laser desorption/ionization time-of-flight (MALDI-TOF) analysis over the range of 100 to 1,000 m/z.

Methanol was used as the solvent, the graph in FIG. 7A illustrates the analysis result of [SnO₂(CH₃COOH)₂+H]⁺, and the graph in FIG. 7B illustrates the analysis result of [SnO₂(CH₃COOH)₂+Na]⁺. In the graph in FIG. 7A, the peak in the 272.929 Da region represents [SnO₂(CH₃COOH)₂+H]⁺, and the peak in the 294.944 Da region represents [SnO₂(CH₃COOH)₂+Na]⁺.

Through this, the molecular structure of the inorganic photosensitive material is determined.

### Manufacturing Example 2: Preparation of inorganic photosensitive layer pattern

The acetic acid-stabilized tin dioxide synthesized in Manufacturing Example 1 was dissolved in 2 wt% ethyl lactate to form a coating solution. The coating solution, which corresponds to an inorganic photosensitive solution, was applied to a silicon wafer and spin-coated at 3,000 rpm to form an inorganic photosensitive layer.

Subsequently, a 5kV electron beam was irradiated to form a pattern, and whether the inorganic photosensitive layer acted as a negative tone photoresist was confirmed. The inorganic photosensitive layer, which is selectively irradiated with the electron beam, was heated at 230 °C for 1 minute to convert the irradiated area into an insoluble state.

Subsequently, 2.38% TMAH was introduced to remove the inorganic photosensitive layer other than the pattern.

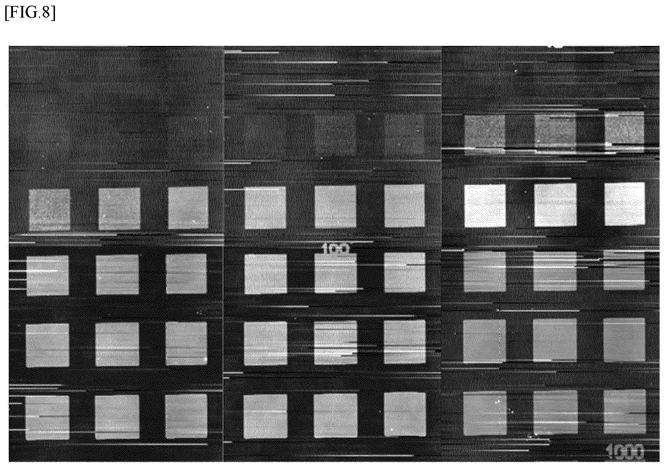

FIG. 8 is an image illustrating the inorganic photosensitive layer pattern formed according to Manufacturing Example 2 of the present invention.

Referring to FIG. 8, it was confirmed that the inorganic photosensitive layer pattern formed with acetic acid-stabilized tin dioxide is regularly formed. In addition, it was confirmed that areas not irradiated with the electron beam were precisely removed by a developing solution containing TMAH.

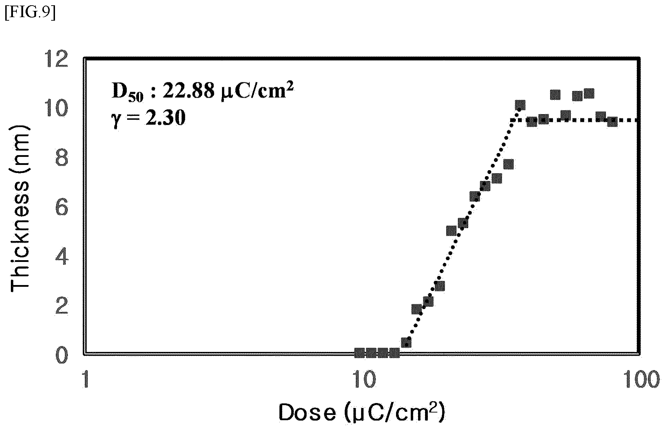

FIG. 9 is a graph obtained by measuring the sensitivity of the inorganic photosensitive layer according to Manufacturing Example 2 of the present invention.

Referring to FIG. 9, the sensitivity to the electron beam was measured under 5 kV electron beam conditions using differences in exposure dose. The calculation of contrast was performed on a logarithmic scale, and the sensitivity was measured while increasing the exposure dose in the patterned area by a factor of 1.1.

The measurement results showed a sensitivity of D50=22.88 µC/cm² and a contrast of γ=2.3.

In addition to Manufacturing Example 2, the inventors of the present invention confirmed the performance of the inorganic photosensitive material under extreme ultraviolet light irradiation conditions. As a result of the confirmation, line patterns of several nanometers (nm) in size were formed.

As confirmed in the above manufacturing example, the inorganic photosensitive material of the present invention does not require a separate photoresist to form a pattern and inherently exhibits negative-type photosensitive characteristics. Hereinafter, the application to transistors will be disclosed through other manufacturing examples.

### Manufacturing Example 3: Preparation of thin-film transistor using inorganic semiconductor

A wafer with 100 nm thick SiO₂ formed on a p++ silicon wafer was provided. The coating solution from Manufacturing Example 1 was prepared for the provided wafer. The coating solution was obtained by dissolving acetic acid-stabilized tin dioxide in 2 wt% ethyl lactate. The coating solution was coated on the provided wafer at a speed of 500 rpm for 5 seconds, followed by spin coating at 3,000 rpm for 30 seconds. In addition, a channel area was irradiated with an electron beam or extreme ultraviolet light.

Subsequently, heating was performed at 150 °C for 1 minute, and then patterning for the channel area was performed through a development process.

After the patterning was completed, the inorganic photosensitive layer pattern was cured at 350 °C for 3 hours under a vacuum atmosphere to modify the inorganic photosensitive layer pattern into an inorganic semiconductor pattern.

Aluminum (Al) was deposited on the inorganic semiconductor pattern, which has semiconductor properties, to form a source electrode and a drain electrode.

A p++ doped silicon wafer acts as a gate electrode, SiO₂ acts as a gate dielectric film, and the inorganic semiconductor pattern acts as a channel layer.

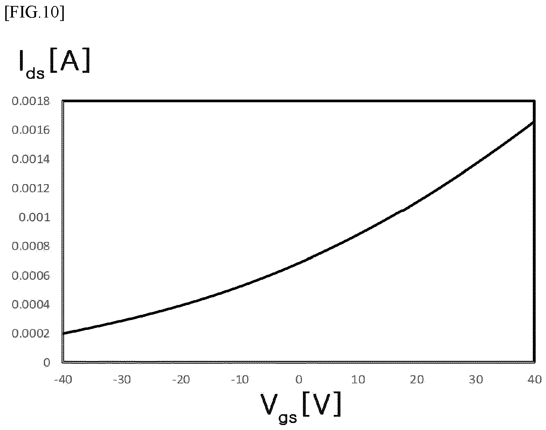

FIG. 10 is a graph illustrating transfer characteristics in a common source configuration of the thin-film transistor according to Manufacturing Example 3 of the present invention.

Referring to FIG. 10, the source electrode was grounded, and a voltage of 40 V was applied to the drain electrode. That is, V_{ds} was fixed at 40 V, and I_{ds} was measured while increasing a gate voltage V_{gs} from -40 V to 40 V in increments of 1 V. It was confirmed that as V_{gs} increases, I_{ds} also increases. In particular, the increase in I_{ds} exhibits an exponential characteristic. This means that an inversion of the channel layer occurs, in which the conductivity of the channel increases as the gate voltage increases.

That is, the confirmation of the transfer characteristics in FIG. 10 verifies that the inorganic semiconductor of the present invention exhibits semiconductor properties.

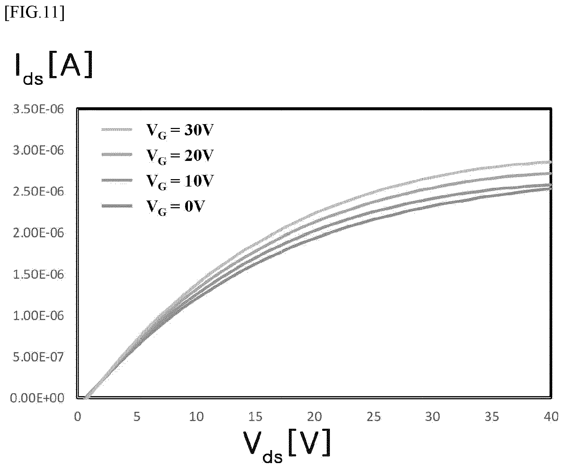

FIG. 11 is a graph for confirming the operation of the thin-film transistor in the saturation region, according to Manufacturing Example 3 of the present invention.

Referring to FIG. 11, the source electrode was grounded, and the gate voltage V_{gs} was applied to the gate electrode. The current I_{ds} flowing through the drain-source was measured while increasing the drain voltage V_{ds}.

When the gate voltage V_{gs} increased, the inorganic semiconductor layer forming the channel layer was turned on and operated in the linear region. That is, as V_{ds} increases, a region in which I_{ds} increases linearly also appears. However, as Vds increases further, a pinch-off occurs in the channel layer near the drain electrode, and the inorganic semiconductor layer, which is the channel layer, operates in the saturation region. When the thin-film transistor operates in the saturation region, the thin-film transistor can be used as a current source or an amplifier.

In the present invention described above, the inorganic photosensitive layer composed of acetic acid-stabilized tin dioxide can be patterned through irradiation with extreme ultraviolet light or electron beams. That is, there is no need to apply a separate photoresist on top to form the pattern. The patterned inorganic photosensitive layer is modified into an inorganic semiconductor layer through heat treatment. Accordingly, processes for forming the inorganic semiconductor layer, such as applying a photoresist, forming a photoresist pattern through a lithography process, and using the photoresist pattern as an etch mask to form a pattern, may be omitted.

Thus, a process for patterning a channel layer may be significantly reduced, and productivity may be ensured.

According to the present invention described above, an inorganic photosensitive layer including acetic acid-stabilized tin dioxide can be patterned by irradiation with extreme ultraviolet light or electron beams. That is, there is no need to apply a separate photoresist on top to form the pattern. The patterned inorganic photosensitive layer is modified into an inorganic semiconductor layer through heat treatment. Accordingly, processes for forming the inorganic semiconductor layer, such as applying a photoresist, forming a photoresist pattern through a lithography process, and using the photoresist pattern as an etch mask to form a pattern, can be omitted.

Thus, a process for patterning a channel layer can be significantly reduced, and productivity can be ensured.

## Claims

1. A thin-film transistor comprising:
a gate electrode;
a gate dielectric film formed on the gate electrode;
an inorganic semiconductor layer formed on the gate dielectric film; and
a source electrode and a drain electrode formed on the inorganic semiconductor layer,
wherein the inorganic semiconductor layer is modified from acetic acid-stabilized tin dioxide through heat treatment.

2. The thin-film transistor of claim 1, wherein the acetic acid-stabilized tin dioxide has a composition of SnO₂(CH₃COOH)₂.

3. The thin-film transistor of claim 2, wherein acetic acid in the acetic acid-stabilized tin dioxide is removed through the heat treatment.

4. The thin-film transistor of claim 2, wherein the inorganic semiconductor layer has a network structure of tin oxide, in which Sn-O-Sn bonds are repeated.

5. The thin-film transistor of claim 2, wherein the inorganic semiconductor layer includes CH₃COOH.

6. A method of manufacturing a thin-film transistor, the method comprising:
forming a gate electrode;
forming a gate dielectric film on the gate electrode;
forming an inorganic semiconductor layer, which is modified from an inorganic photosensitive layer pattern including acetic acid-stabilized tin oxide, on the gate dielectric film; and
forming a source electrode and a drain electrode on the inorganic semiconductor layer,
wherein the inorganic semiconductor layer is formed by performing heat treatment on the inorganic photosensitive layer pattern.

7. The method of claim 6, wherein the acetic acid-stabilized tin oxide has a composition of SnO₂(CH₃COOH)₂.

8. The method of claim 7, wherein acetic acid is removed from the inorganic photosensitive layer pattern by the heat treatment.

9. The method of claim 7, wherein the inorganic photosensitive layer pattern is modified into the inorganic semiconductor layer, which has a tin oxide network with repeated Sn-O-Sn bonds, by the heat treatment.

10. The method of claim 6, wherein the forming of the inorganic semiconductor layer includes:
forming the inorganic photosensitive layer by applying a coating solution including the acetic acid-stabilized tin oxide on the gate dielectric film;
forming the inorganic photosensitive layer pattern by irradiating the inorganic photosensitive layer with an electron beam or extreme ultraviolet light; and
modifying the inorganic photosensitive layer pattern into the inorganic semiconductor layer by performing heat treatment on the inorganic photosensitive layer pattern at a temperature condition of 300 °C to 450 °C.

11. The method of claim 10, wherein the forming of the inorganic photosensitive layer pattern includes:
irradiating the inorganic photosensitive layer with the electron beam or extreme ultraviolet light;
converting the irradiated area into an insoluble state by baking at 200 °C to 250 °C; and
using tetramethylammonium hydroxide (TMAH) to remove a non-irradiated area and form a pattern with the insoluble irradiated area after the baking.

12. The method of claim 10, wherein the coating solution is formed by dissolving an inorganic photosensitive material, which is acetic acid-stabilized tin dioxide with a composition of SnO₂(CH₃COOH)₂, in ethyl lactate.

13. The method of claim 12, wherein the inorganic photosensitive material is prepared by including:
mixing tin oxide powder with methanol to form a mixed solution; and
adding acetic acid to the mixed solution, inducing a reaction, and obtaining a powder of the acetic acid-stabilized tin dioxide.

14. The method of claim 13, wherein, after adding the acetic acid, the reaction is induced at a temperature between 60 °C and 90 °C.

15. The method of claim 10, wherein the inorganic photosensitive layer pattern has a molecular structure shown below; 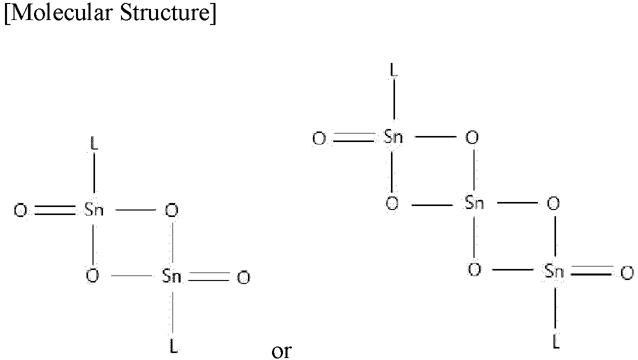 wherein in the molecular structure, L represents a ligand CH₃COOH.

16. The method of claim 15, wherein the inorganic photosensitive layer pattern has a shape retention by forming van der Waals bonds between double-bonded oxygen at a terminal of the molecular structure and a ligand L of another molecular structure.
